(19) Europäisches Patentamt / European Patent Office / Office européen des brevets

(11) **EP 3 657 188 B1**

(12) **EUROPEAN PATENT SPECIFICATION**

(45) Date of publication and mention
of the grant of the patent:
**26.05.2021  Bulletin 2021/21**

(51) Int Cl.:
***G01R 31/34*** *(2020.01)*

(21) Application number: **19206751.0**

(22) Date of filing: **01.11.2019**

(54) **HEALTH MONITORING METHOD AND DEVICE FOR A PERMANENT MAGNET ELECTRIC MACHINE**

GESUNDHEITSÜBERWACHUNGSVERFAHREN UND -VORRICHTUNG FÜR EINE ELEKTRISCHE DAUERMAGNETMASCHINE

PROCÉDÉ DE SURVEILLANCE DE LA SANTÉ ET DISPOSITIF POUR MACHINE ÉLECTRIQUE À AIMANT PERMANENT

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority:  **02.11.2018  NO 20181409**

(43) Date of publication of application:
**27.05.2020  Bulletin 2020/22**

(73) Proprietor: **Kongsberg Maritime AS**
**3183 Horten (NO)**

(72) Inventors:
  • **SWIDER, Krzysztof**
    **6066 Ulsteinvik (NO)**
  • **SOLÅS, Leif Rune**
    **6065 Ulsteinvik (NO)**
  • **OKSAVIK, Thomas**
    **3183 Horten (NO)**

(74) Representative: **Acapo AS**
**P.O. Box 1880 Nordnes**
**5817 Bergen (NO)**

(56) References cited:
  • FAIZ JAWAD ET AL: "Demagnetization Modeling and Fault Diagnosing Techniques in Permanent Magnet Machines Under Stationary and Nonstationary Conditions: An Overview", IEEE TRANSACTIONS ON INDUSTRY APPLICATIONS, IEEE SERVICE CENTER, PISCATAWAY, NJ, US, vol. 53, no. 3, 1 May 2017 (2017-05-01), pages 2772-2785, XP011650195, ISSN: 0093-9994, DOI: 10.1109/TIA.2016.2608950 [retrieved on 2017-05-18]
  • AHSANULLAH KAZI ET AL: "Detection and analysis of winding and demagnetization faults in PMSM based marine propulsion motors", 2017 IEEE INTERNATIONAL ELECTRIC MACHINES AND DRIVES CONFERENCE (IEMDC), IEEE, 21 May 2017 (2017-05-21), pages 1-7, XP033137117, DOI: 10.1109/IEMDC.2017.8002050 [retrieved on 2017-08-03]
  • ZHU MIN ET AL: "Torque-Ripple-Based Interior Permanent-Magnet Synchronous Machine Rotor Demagnetization Fault Detection and Current Regulation", IEEE TRANSACTIONS ON INDUSTRY APPLICATIONS, IEEE SERVICE CENTER, PISCATAWAY, NJ, US, vol. 53, no. 3, 1 May 2017 (2017-05-01), pages 2795-2804, XP011650266, ISSN: 0093-9994, DOI: 10.1109/TIA.2016.2634518 [retrieved on 2017-05-18]

• SALAH MOHAMED ET AL: "SEIG-based wind turbine condition monitoring using stray flux instantaneous frequency estimation", 2015 IEEE 24TH INTERNATIONAL SYMPOSIUM ON INDUSTRIAL ELECTRONICS (ISIE), IEEE, 3 June 2015 (2015-06-03), pages 861-866, XP033223045, DOI: 10.1109/ISIE.2015.7281583 [retrieved on 2015-09-28]

**Description**

**Area of the invention**

The present invention generally relates to electric machines, and more particularly to a health monitoring method and a device for permanent magnet electric machine. It also relates to an electric machine system comprising such a device. More specifically, the invention is based on signals provide by search coils arranged on stator teeth, and the use of a Hilbert band-pass analytic filter in the processing of signals from said search coils.

**Background of the invention**

For mechanical machines, traditional equipment health monitoring solutions have been used with success for over 40 years. The developed range of the monitoring techniques is limited to tasks for which they were dedicated. Recent years, research activities in the marine area have result in a new class of electric machines - Permanent Magnet (PM). The PM machines do not have a classical construction including example shaft, geared mechanism connected to a motor etc.. Therefore the standard monitoring techniques are not suitable. The Permanent Magnet Electric Machines require a new matched diagnostic technique for monitoring which can provide a solution for fault detection, fault diagnosis and fault prognosis.

**Prior art**

Patent application US 2013/0033215 A1 "*Apparatus and method for permanent magnet electric machine condition monitoring*" presents an apparatus and method for determining a health of an electric machine. The solution according to '215 is based on the Parker Transform where Rotations Per Minute (RPM) is estimated based on many search coil signals. The US patent 2013/0033215 A1 presents 2 algorithms for estimation of instantaneous phase/position of rotor; one for digital signals and one for analog signals making use of a Park Transformation which "transforms" 3-phase currents and voltages into single phasors u and I. Based on these phasors, the instantaneous phase (position of rotor) is estimated. Both when it comes to estimating the eccentricity of the electric machine and problems with magnets in the rotor, more than two search coils are needed. Problems with the solution according to patent application '215 are that it is complicated by the number of search coils needed. The number of search coils also increases cost both when it comes to manufacturing and operating the solution.
Patent application US 2013/0108488 A1 "*Permanent magnet motor pump*" presents an invention relating to a seal-less canned motor pump, more particularly to an anticorrosion and seal-less canned motor pump including a bearing monitor device.
Patent application US 2013/0325373 A1 "*Detecting faults in wind turbines*" presents wind turbines generating sustainable electricity. The reliability of such wind turbines can be a direct correlation to proper installation and maintenance of the turbines. This reliability can be improved upon by using various condition monitoring methods to ensure device functionality. Further such art is taught in the papers "Demagnetization Modeling and Fault Diagnosing Techniques in Permanent Magnet Machines Under Stationary and Nonstationary Conditions: An Overview", by Fiaz et al, IEEE TRANSACTIONS ON INDUSTRY APPLICATIONS, IEEE SERVICE CENTER, PISCATAWAY, NJ, US, vol. 53, no. 3, 1 May 2017, pages 2772-2785; "Detection and analysis of winding and demagnetization faults in PMSM based marine propulsion motors", by Ahsanullah et al, IEEE INTERNATIONAL ELECTRIC MACHINES AND DRIVES CONFERENCE (IEMDC), IEEE, 21 May 2017, pages 1-7; "Torque-Ripple-Based Interior Permanent-Magnet Synchronous Machine Rotor Demagnetization Fault Detection and Current Regulation", by Zhu et al, IEEE TRANSACTIONS ON INDUSTRY APPLICATIONS, IEEE SERVICE CENTER, PISCATAWAY, NJ, US, vol. 53, no. 3, 1 May 2017, pages 2795-2804; and "SEIG-based wind turbine condition monitoring using stray flux instantaneous frequency estimation", by Mohamed et al, IEEE 24TH INTERNATIONAL SYMPOSIUM ON INDUSTRIAL ELECTRONICS (ISIE), IEEE, 3 June 2015, pages 861-866.
The prior art monitoring solutions in the present area exhibit one or more of the problems listed below: complex solutions, expensive both when it comes to manufacturing and operation/maintenance, and requiring a plurality of search coils.

**Objects of the present invention**

The general object of the invention is to provide a method, a device and an electric machine capable solving one or more of the problems with solutions according to state of art in general, and according to the problems identified above in particular.
A further object is to provide a simpler and more cost efficient solution.

More specifically, an object of the present invention is to provide health monitoring of an electric machine based fewer search coils than prior art solutions.

Even more specifically, an object of the present invention is to provide RPM (Rotations Per Minute) estimation based on only one search coil.

A further specific object, is to provide a solution for visualization of problems with magnets in rotor based on only one search coil.

A still further object, is to provide a solution for visualization of eccentricity based on two search coils.

**Summary of the invention**

The objectives and advantages are achieved by a method, a device and an electric machine as defined in the independent claims. Preferred embodiments are also defined in the dependent claims.

A first aspect of the invention is a health monitoring method for a permanent magnet electric machine, where the electric machine comprises a rotor with a number of permanent magnets, and a stator with stator teeth, and where at least a first search coil is arranged on a first of the stator teeth. The method comprises the following steps:

I) Initial steps:

- establishing a state baseline based on one of the following: i) a predefined state baseline, and ii) a current state for the PM electric machine in faultless operation, where the current state is established by the steps below of preprocessing, filtering, extracting, and establishing the current state;

II) Operational steps:

- preprocessing an analogue search coil signal from each search coil by applying an anti-aliasing filter providing an anti-aliased search coil signal, and converting the anti-aliased search coil signal to a digital search coil signal;
- filtering the digital search coil signal by a band-pass analytic Hilbert filter, providing an analytic search coil signal;
- extracting features from the analytic search coil signal;
- establishing a current state based on the extracted features;
- monitoring the health of the permanent magnet electric machine based on the current state and the state baseline.

Preferably, the digital search coil signal $s[n]$ is filtered by the band-pass analytic Hilbert filter providing the (complex) analytic signal $u[n] = H\{s[n]\}$ where H has a frequency response given by the equation:

$$H(f) = \begin{cases} 2 & \text{for } 0 \leq f \leq f_c \\ 0 & \text{for } f < 0 \\ 0 & \text{for } f > f_c \end{cases} \quad ; \quad f \in [-0.5, 0.5)$$

where $f$ is a normalized frequency given by the equation below

$$f = \frac{F}{F_s}; \quad f \in [-0.5, 0.5)$$

where Fs is a sampling frequency [$S_a$/s] and fc is a normalized cutoff frequency.

Optionally, the step of extracting features for the first search coil, comprises the following steps: calculating the instantaneous amplitude as the absolute value of the analytic search coil signal, estimating the instantaneous frequency based on the analytic search coil signal, and accumulating the instantaneous phase based on the instantaneous frequency. The instantaneous frequency is preferably estimated based on one analytic search coil $u_1$ signal even if more search coil signals should be available

$$f_{inst}[n] = \frac{\text{Im}\left(\ln\left(\frac{u_1[n]}{u_1[n-1]}\right)\right)}{2\pi n_m} \quad ,$$

where Im means the imaginary part, In means natural logarithm, n is a discrete time [Sa], and $n_m$ means the number of the magnets in the rotor, and where the instantaneous phase is obtained from the instantaneous frequency in the following way:

$$\varphi[n] = \left\{ \begin{array}{ll} 0 & \text{for } n = -1 \\ 2\pi\text{fr}(f_{inst}[n] + \frac{\varphi[n-1]}{2\pi}) & \text{for } n = 0, 1, \ldots \end{array} \right.$$

where fr() means the fraction function.

Optionally, when the electric machine comprises a second search coil arranged on a second of the stator teeth, and arranged in an angle of 90 degrees to the first search coil, where the step of extracting features for the second search coil, comprises only the following step: calculating the instantaneous amplitude as the absolute value of the analytic search coil signal.

Optionally, the step of extracting features comprises calculating a complex output signal based on the instantaneous amplitudes of the first and second search coil signals and the instantaneous phase of the second search coil signal. The output signal prerferably is calculated according to the following equation:

$$w[n] = (a_1[n] + j \cdot a_2[n])e^{j(\varphi[n])};$$

where $j = \sqrt{-1}$ and where $a_1$ and $a_2$ are the instantaneous amplitudes of the first and second search coil signals, and $\varphi[n]$ is the instantaneous phase of the first search coil signal.

Preferably, the step monitoring comprises presenting a view of the current state and a corresponding view of the state baseline in a common coordinate system arranged for visual inspection. The step of presenting can comprises displaying the instantaneous amplitude as a function of the instantaneous phase for the current state and the corresponding state baseline in an common eye diagram.

Preferably, the step of monitoring comprises presenting the complex output signal *w[n]* as 2D plot.

The step of monitoring can comprises the following steps:

- calculating deviations between the current state and the state baseline; and at least one of the following steps:
- i) presenting the deviations arranged for manual evaluation; and
- ii) automatically evaluating the deviations.

The step of automatically evaluating the deviations can be computerized.

A further aspect of the invention is a health monitoring device for a permanent magnet electric machine, where the electric machine comprises a rotor with a number of permanent magnets, and a stator with stator teeth, and where at least a first search coil is arranged on a first of the stator teeth, where the device is arranged for performing the method described above. The device comprises the at least first search coil, means for receiving a search coil signal from the at least first search coil, means for converting an analogue search coil signal from the search coil, to a digital search coil signal, means for filtering the digital search coil signal by a Hilbert band pass analytic filter, to an analytic signal, means for extracting amplitude, instantaneous frequency and instantaneous phase of the analytic signal, and means for monitoring the health.

The means of the device preferably can comprise a computer and a monitor for presenting.

A still further aspect of the invention is a permanent magnet electric machine system, comprising a permanent magnet electric machine comprising a rotor with a number of permanent magnets, a stator with stator teeth, and a health monitoring device as described above.

Optionally, the health monitoring device comprises only one search coil, and the search coil is arranged around one of the stator teeth. Optionally, the health monitoring device comprises two search coils arranged on separate stator teeth such that the central axes of the two search coils are orthogonal.

**Brief description of the figures**

The above and further features of the invention are set forth with particularity in the appended claims and together with advantages thereof will become clearer from consideration of the following detailed description of an exemplary embodiment of the invention given with reference to the accompanying drawings.

The invention will be further described below in connection with exemplary embodiments which are schematically shown in the drawings, wherein:

- Figure 1 presents a stator of a permanent magnet electric machine according to the invention, where two search coils are mounted on teeth placed 90 degrees to each other
- Figure 2 presents a block diagram of an algorithm according to the invention
- Figure 3 presents an example of visualization in the form of an "eye diagram" where estimated instantaneous amplitude is presented as a function of estimated instantaneous phase
- Figure 4 presents an example of visualization in the form of a 2D diagram of a complex signal based two search coil signals
- Figure 5 examples of visualization of the health of an electric machine, here a PM Thruster, as follows: (a) baseline, (b) problem with the magnet, and (c) problem with the eccentricity.

## Description of preferred embodiments of the invention

Various aspects of the disclosure are described more fully hereinafter with reference to the accompanying drawings. This disclosure may, however, be embodied in many different forms and should not be construed as limited to any specific structure or function presented throughout this disclosure. Rather, these aspects are provided so that this disclosure will be thorough and complete, and will fully convey the scope of the disclosure to those skilled in the art. Based on the teachings herein one skilled in the art should appreciate that the scope of the disclosure is intended to cover any aspect of the disclosure disclosed herein, whether implemented independently of or combined with any other aspect of the disclosure. For example, an apparatus may be implemented or a method may be practiced using any number of the aspects set forth herein. In addition, the scope of the disclosure is intended to cover such an apparatus or method which is practiced using other structure, functionality, or structure and functionality in addition to or other than the various aspects of the disclosure set forth herein. It should be understood that any aspect of the disclosure disclosed herein may be embodied by one or more elements of a claim.

The invention will be further described in connection with exemplary embodiments which are schematically shown in the drawings.

In the present description, a method and a device for health monitoring of a PM (Permanent Magnet) electric machine are presented. Also an electric machine comprising such a device is presented. Health monitoring is in this context including monitoring of individual magnet's magnetic field strength. It may also include monitoring of the balance or deformation of the rotor in the electrical machine.

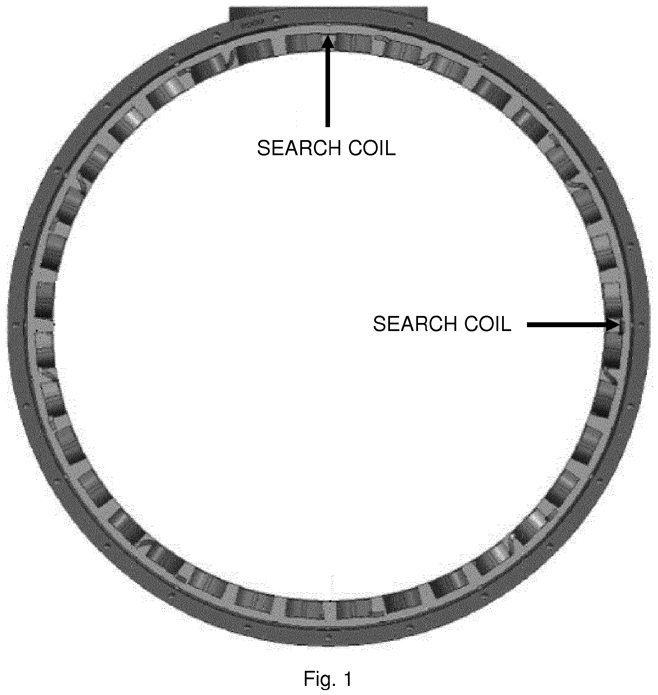

Figure 1 presents a stator of a permanent magnet electric machine according to the invention. Two search coils are arranged on two stator teeth placed with an angular separation of 90 degrees. The search coils are affected by the magnetic field of a passing magnet. This magnetic field induces a voltage in each of the search coils, and these voltages can be picked up by a connected data acquisition system. By measuring and acquiring the induced voltages, a monitoring device/system can monitor the field strength of the individual magnets of the rotor being directly dependent on the magnetization.

Figure 1 presents a solution with two search coils. Solutions with only one search coil is also relevant for certain embodiments of the invention. Also embodiments with more than two search coils are comprised.

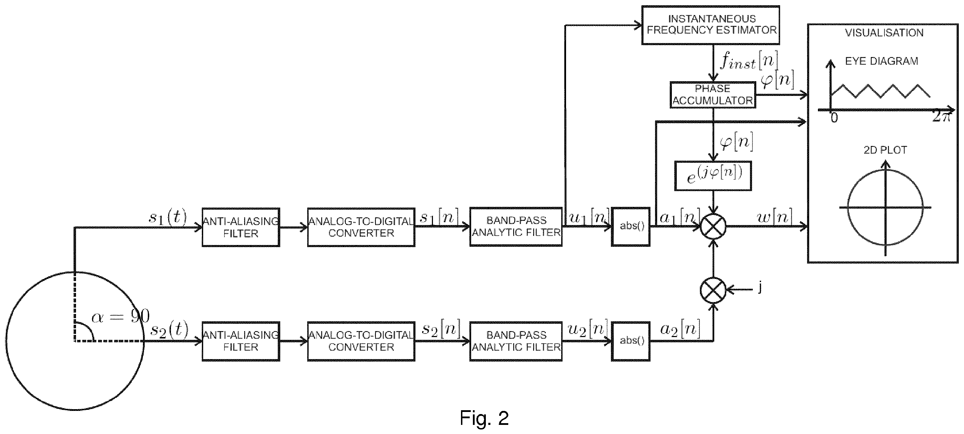

Figure 2 depicts an embodiment of an algorithm comprised by the method according to the invention. The method is based on the search coil signals, and provides condition/health monitoring i.e. magnet health monitoring, eccentricity and other failure modes of the permanent magnet electric machine.

More concretely, Figure 1 presents a block diagram of the algorithm, where:

$s_1(t)$ - analog search coil signal from sensor 1,
$s_2(t)$ - analog search coil signal from sensor 2,
$\alpha$ - angle between search coil sensors,
$s_1[n]$ - digital search coil signal,
$s_2[n]$ - digital search coil signal,
$u_1[n]$ - analytic signal,
$u_2[n]$ - analytic signal,
$a_1[n]$ - instantaneous amplitude,
$a_2[n]$ - instantaneous amplitude,
$f_{inst}[n]$ - instantaneous frequency,
$\varphi[n]$ - instantaneous phase,
$w[n]$ - complex signal,

$F_s$ - sampling frequency,
$f_c$ - normalized cutoff frequency

The proposed algorithm provides extraction of features of the electric machine from the search coil signals ($s_1(t)$ and $s_2(t)$). The search coil signals contain information about the magnet health and forces/interactions between the magnets and stator windings of the electric machine. Each magnets magnetic field is measured indirectly from the voltage induced by the coil that the field passes through the sensors location. Unfortunately, it is very difficult to extract this information from the raw data from the search coils. Because this sensor is a coil measuring induced voltages, it also picks up electrical noise from the rest of the machine. This approach based on the theory of the complex signals allows for extraction of amplitude and frequency from the real signal. It should be noticed, that the information about the magnets field strength is in the amplitudes ($a_1[n]$ and $a_2[n]$) of the search coil signals. Information about the speed of the rotation of the rotor is represented by the instantaneous frequency ($f_{inst}[n]$) of the search coil signal ($s_1(t)$ or $s_2(t)$). The algorithm can be seen as three steps:

1. Data preprocessing (comprising anti-aliasing and AD conversion) and feature extraction: in this step, the information about the amplitude and frequency is extracted based on search coil signals $s_1(t)$ and $s_2(t)$ making use of a Hilbert band pass analytic filter transform. The instantaneous frequency and phase is estimated based on search coil signal from only one search coil.
2. Visualization: in this step, a complex signal $w[n]$ is depicted in a 2D plot and instantaneous amplitude as a function of instantaneous phase is depicted in an "eye diagram".
3. Health prognosis and failures detection: in this step the state of the health is evaluated based on the discrepancies from the expected/predefined baseline behavior. This may be performed manually by visual inspection, or automatically e.g. by the use of a Machine Learning Algorithm (MLA).

In more detail, the algorithm can be described as follows. The algorithm works based on two analog search coil signals $s_1(t)$ and $s_2(t)$. We assume that the angle between the sensors $\alpha$ is equal 90 degrees. For a solution based on only 2 search coil signals, this condition has to be fulfilled.

In a first, step both signals $s_1(t)$ and $s_2(t)$ are converted into digital signals (with respect to the sampling theory), it means:

$$s_1[n] = s_1(t)|_{t=n/F_s}; \qquad n = 0, 1, \ldots$$

$$s_2[n] = s_2(t)|_{t=n/F_s}; \qquad n = 0, 1, \ldots$$

$$s_1[n] = s_1(t)|_{t=n/Fs} \; ; n = 0, 1, \ldots \; (1)$$

$$s_2[n] = s_2(t)|_{t=n/Fs} \; ; n = 0, 1, \ldots \; (2)$$

where $s_1[n]$ and $s_2[n]$ are the digital signals, Fs is the sampling frequency [$S_a$/s] and $n$ is the discrete time [Sa]. In the next step, both digital signals $s_1[n]$ and $s_2[n]$ are filtered by the band-pass analytic Hilbert filter, with a frequency response given by the equation:

$$H(f) = \begin{cases} 2 & \text{for } 0 \leq f \leq f_c \\ 0 & \text{for } f < 0 \\ 0 & \text{for } f > f_c \end{cases} \; ; \qquad f \in [-0.5, 0.5)$$

$$(3)$$

where $f$ is a normalized frequency given by equation (4) below, and $f_c$ is a normalized cutoff frequency.

$$f = \frac{F}{F_s}; \qquad f \in [-0.5, 0.5) \quad \text{Eq. (4)}$$

At the outputs of both analytic filters, the complex analytical signals $u_1[n]$ and $u_2[n]$ are received:

$$u_1[n] = H\{s_1[n]\}, \qquad \text{Eq. (5)}$$

$$u_2[n] = H\{s_2[n]\}, \qquad \text{Eq. (6)}$$

The instantaneous amplitudes (envelopes) are calculated based on the analytic signals in the following way:

$$a_1[n] = |u_1[n]| \quad (7)$$

$$a_2[n] = |u_2[n]| \quad (8)$$

Additionally, the instantaneous frequency is estimated, based on the signal $u_1[n]$ in accordance with Eq. 9 below. This implies that the instantaneous frequency is estimated based on one search coil signal even if more search coil signals should be available.

$$f_{inst}[n] = \frac{\text{Im}\left(\ln\left(\frac{u_1[n]}{u_1[n-1]}\right)\right)}{2\pi n_m} \quad \textit{Eq. (9)}$$

where Im means the imaginary part of the complex number, ln means natural logarithm and $n_m$ means the number the magnets in the rotor. The instantaneous phase is obtained from the instantaneous frequency in the following way:

$$\varphi[n] = \begin{cases} 0 & \text{for } n = -1 \\ 2\pi\text{fr}(f_{inst}[n] + \frac{\varphi[n-1]}{2\pi}) & \text{for } n = 0, 1, \ldots \end{cases}$$

$$\textit{Eq. (10)}$$

where fr() means the fraction function . Finally, the output signal according to Eq. 11 below is used for the visualization:

$$w[n] = (a_1[n] + j \cdot a_2[n])e^{j(\varphi[n])};$$

$$\textit{Eq. (11)}$$

where $j = \sqrt{-1}$

The last step is the health prognosis and failures detection. First, the health baseline is established. For the Permanent Magnet electric machine, the health baseline has a symmetrical, circular shape (2D plot) or a regular pattern in the "eye diagram". A failure is indicated when a deviation from the baseline is detected. The deviations can e.g. be result of a loss of magnet strength or an eccentricity. Both cases are depicted in figure 2 as detailed below.

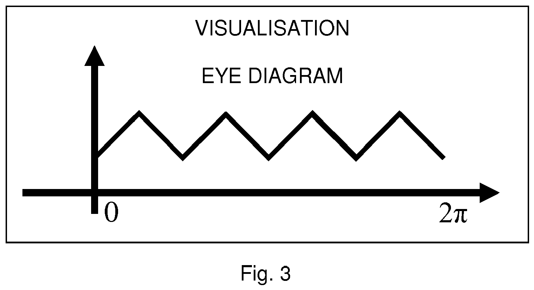

Figure 3 presents an example of visualization in the form of an "eye diagram" where estimated instantaneous amplitude is presented as a function of estimated instantaneous phase. The eye diagram is created by taking the time domain signal and overlapping the waveform at a time window defined by values of instantaneous phase.

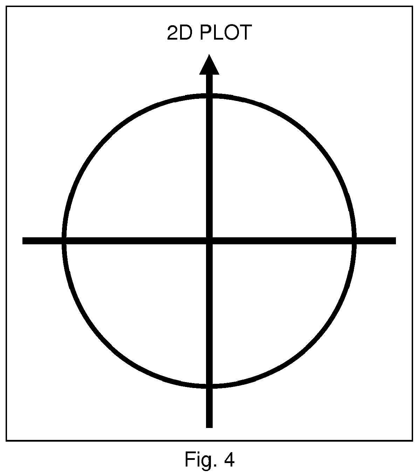

Figure 4 presents an example of visualization in the form of a 2D diagram of a complex signal based two search coil signals.

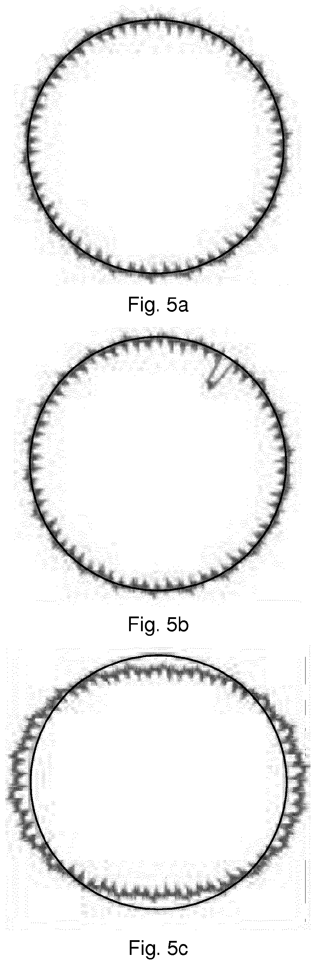

Figure 5 examples of visualization of the health of an electric machine, here a PM Thruster, as follows: (a) baseline, (b) problem with the magnet, and (c) problem with the eccentricity.

**Industrial applicability**

The described invention is suitable in a range of applications for electric machines. The invention is a cost-effective solution for providing health monitoring of such electric machines.

**Claims**

1.  A health monitoring method for a permanent magnet electric machine, where the electric machine comprises a rotor with a number of permanent magnets, and a stator with stator teeth, and where at least a first search coil is arranged on a first of the stator teeth, where the method comprises the following steps:

    I) Initial steps:

      - establishing a state baseline based on one of the following: i) a predefined state baseline, and ii) a current state for the PM electric machine in faultless operation, where the current state is established by the steps below of preprocessing, filtering, extracting, and establishing the current state;

    II) Operational steps:

      - preprocessing an analogue search coil signal from each search coil by applying an anti-aliasing filter providing an anti-aliased search coil signal, and converting the anti-aliased search coil signal to a digital search coil signal;
      - filtering the digital search coil signal by a band-pass analytic Hilbert filter, providing an analytic search coil signal;
      - extracting features from the analytic search coil signal;
      - establishing a current state based on the extracted features;
      - monitoring the health of the permanent magnet electric machine based on the current state and the state baseline.

2.  Method according to claim 1, where the digital search coil signal $s[n]$ is filtered by the band-pass analytic Hilbert filter providing the (complex) analytic signal $u[n] = H\{s[n]\}$ where H has a frequency response given by the equation:

$$H(f) = \begin{cases} 2 & \text{for } 0 \le f \le f_c \\ 0 & \text{for } f < 0 \\ 0 & \text{for } f > f_c \end{cases} \quad ; \qquad f \in [-0.5, 0.5)$$

where $f$ is a normalized frequency given by the equation below

$$f = \frac{F}{F_s}; \qquad f \in [-0.5, 0.5)$$

where Fs is a sampling frequency [$S_a$/s].

3.  Method according to one of the claims above, where the step of extracting features for the first search coil, comprises the following steps:

      - calculating the instantaneous amplitude as the absolute value of the analytic search coil signal,
      - estimating the instantaneous frequency based on the analytic search coil signal; and
      - accumulating the instantaneous phase based on the instantaneous frequency.

4.  Method according to claim 3, where the instantaneous frequency is estimated based on one analytic search coil $u_1$ signal even if more search coil signals should be available

$$f_{inst}[n] = \frac{\text{Im}\left(\ln\left(\frac{u_1[n]}{u_1[n-1]}\right)\right)}{2\pi n_m},$$

where Im means the imaginary part, ln means natural logarithm, and $n$ is a discrete time [Sa], and $n_m$ means the number of the magnets in the rotor, and where the instantaneous phase is obtained from the instantaneous frequency in the following way:

$$\varphi[n] = \begin{cases} 0 & \text{for } n = -1 \\ 2\pi\text{fr}(f_{inst}[n] + \frac{\varphi[n-1]}{2\pi}) & \text{for } n = 0, 1, \ldots \end{cases}$$

where fr() means the fraction function.

5. Method for evaluating the health of a permanent magnet electric machine according to one of the claims above, where the electric machine comprises a second search coil arranged on a second of the stator teeth, and arranged in an angle of 90 degrees to the first search coil, where the step of extracting features for the second search coil, comprises the following step:

- calculating the instantaneous amplitude as the absolute value of the analytic search coil signal.

6. Method according to claim 5, where the step of extracting features further comprises calculating a complex output signal based on the instantaneous amplitudes of the first and second search coil signals and the instantaneous phase of the second search coil signal.

7. Method according to claim 6, where the output signal is calculated according to the following equation:

$$w[n] = (a_1[n] + j \cdot a_2[n])e^{j(\varphi[n])}; \quad \text{where } j = \sqrt{-1}$$

and where $a_1$ and $a_2$ are the instantaneous amplitudes of the first and second search coil signals, and $\varphi[n]$ is the instantaneous phase of the first search coil signal.

8. Method according to one of the claims above, where the step of monitoring comprises the following steps:

- presenting a view of the current state and a corresponding view of the state baseline in a common coordinate system arranged for visual inspection.

9. Method according to claim 8, where the step of presenting comprises displaying the instantaneous amplitude as a function of the instantaneous phase for the current state and the corresponding state baseline in a common eye diagram.

10. Method according to one of the claims 7 to 9, where the step of monitoring further comprises presenting the complex output signal *w[n]* as 2D plot.

11. Method according to claim 2, where the step of monitoring comprises the following steps:

- calculating deviations between the current state and the state baseline; and at least one of the following steps:
- i) presenting the deviations arranged for manual evaluation; and
- ii) automatically evaluating the deviations.

12. Method according to claim 11, where the step of automatically evaluating the deviations is computerized.

13. A health monitoring device for a permanent magnet electric machine, where the electric machine comprises a rotor with a number of permanent magnets, and a stator with stator teeth, and where at least a first search coil is arranged on a first of the stator teeth, where the device is arranged for performing the method according to one of the claims above, and where the device comprises:

- the at least first search coil;
- means for receiving a search coil signal from the at least first search coil;
- means for converting an analogue search coil signal from the search coil, to a digital search coil signal;
- means for filtering the digital search coil signal by a Hilbert band pass analytic filter, to an analytic signal;
- means for extracting amplitude, instantaneous frequency and instantaneous phase of the analytic signal; and
- means for monitoring the health.

14. Health monitoring device according to claim 13, where the means comprises a computer and a monitor.

15. A permanent magnet electric machine system, comprising:

- a permanent magnet electric machine comprising a rotor with a number of permanent magnets, a stator with stator teeth; and
- a health monitoring device according to one of the claims 13 - 14.

16. System according to claim 15, where the health monitoring device comprises only one search coil, and the search coil is arranged around one of the stator teeth.

17. System according to claim 15, where the health monitoring device comprises two search coils arranged on separate stator teeth such that the central axes of the two search coils are orthogonal.


**Patentansprüche**

1. Zustandsüberwachungsverfahren für eine permanentmagnetische elektrische Maschine, wobei die elektrische Maschine einen Rotor mit einer Anzahl von Permanentmagneten und einen Stator mit Statorzähnen umfasst, und wobei mindestens eine erste Suchspule an einem ersten der Statorzähne angeordnet ist, wobei das Verfahren die folgenden Schritte umfasst:

I) Anfängliche Schritte:

- Erstellen einer Zustandsbasislinie basierend auf einem der folgenden: i) einer vordefinierten Zustandsbasislinie, und ii) einem aktuellen Zustand für die PM elektrische Maschine im fehlerfreien Betrieb, wobei der aktuelle Zustand durch die folgenden Schritte eines Vorverarbeitens, Filterns, Extrahierens und Erstellens des aktuellen Zustands erstellt wird;

II) Arbeitsschritte:

- Vorverarbeiten eines analogen Suchspulensignals von jeder Suchspule durch Anwenden eines Treppeneffektglättungsfilters, der ein treppeneffektgeglättetes Suchspulensignal liefert, und Umwandeln des treppeneffektgeglätteten Suchspulensignals in ein digitales Suchspulensignal;
- Filtern des digitalen Suchspulensignals durch einen analytischen Hilbert-Bandpassfilter, wodurch ein analytisches Suchspulensignal bereitgestellt wird;
- Extrahieren von Merkmalen aus dem analytischen Suchspulensignal;
- Erstellen eines aktuellen Zustands basierend auf den extrahierten Merkmalen;
- Überwachen des Zustands der permanentmagnetischen elektrischen Maschine basierend auf dem aktuellen Zustand und der Zustandsbasislinie.

2. Verfahren nach Anspruch 1, wobei das digitale Suchspulensignal $s[n]$ durch den analytischen Hilbert-Bandpassfilter gefiltert wird, der das (komplexe) analytische Signal $u[n] = H\{s[n]\}$ bereitstellt, wobei H eine Frequenzantwort aufweist, die durch die Gleichung

$$H(f) = \begin{cases} 2 & \text{for } 0 \le f \le f_c \\ 0 & \text{for } f < 0 \\ 0 & \text{for } f > f_c \end{cases} \quad ; \qquad f \in [-0.5, 0.5)$$

gegeben ist, wobei f eine normierte Frequenz ist, die durch die untere Gleichung

$$f = \frac{F}{F_s}; \qquad f \in [-0.5, 0.5)$$

gegeben ist, wobei Fs eine Abtastfrequenz [$S_a$/s] ist.

3. Verfahren nach einem der oberen Ansprüche, wobei der Schritt des Extrahierens von Merkmalen für die erste Suchspule die folgenden Schritte umfasst:

- Berechnen der momentanen Amplitude als den Absolutwert des analytischen Suchspulensignals,
- Schätzen der momentanen Frequenz basierend auf dem analytischen Suchspulensignal; und
- Akkumulieren der momentanen Phase basierend auf der momentanen Frequenz.

4. Verfahren nach Anspruch 3, wobei die momentane Frequenz basierend auf einem analytischen Suchspulensignal $u_1$ geschätzt wird, selbst wenn mehr Suchspulensignale verfügbar sein sollten

$$f_{inst}[n] = \frac{\text{Im}\left(\ln\left(\frac{u_1[n]}{u_1[n-1]}\right)\right)}{2\pi n_m} ,$$

wobei Im für den Imaginärteil steht, In für den natürlichen Logarithmus steht, n eine diskrete Zeit ist [Sa] und $n_m$ für die Anzahl der Magnete in dem Rotor steht, und wobei die momentane Phase auf folgende Weise von der momentanen Frequenz erhalten wird:

$$\varphi[n] = \begin{cases} 0 & \text{for } n = -1 \\ 2\pi \text{fr}\left(f_{inst}[n] + \frac{\varphi[n-1]}{2\pi}\right) & \text{for } n = 0, 1, \dots \end{cases} ,$$

wobei fr() für die Bruchteilfunktion steht.

5. Verfahren zur Zustandsbewertung einer permanentmagnetischen elektrischen Maschine nach einem der oberen Ansprüche, wobei die elektrische Maschine eine zweite Suchspule umfasst, die an einem zweiten der Statorzähne angeordnet ist und in einem Winkel von 90 Grad zu der ersten Suchspule angeordnet ist, wobei der Schritt des Extrahierens von Merkmalen für die zweite Suchspule den folgenden Schritt umfasst:

- Berechnen der momentanen Amplitude als den Absolutwert des analytischen Suchspulensignals.

6. Verfahren nach Anspruch 5, wobei der Schritt des Extrahierens von Merkmalen ferner das Berechnen eines komplexen Ausgangssignals basierend auf den momentanen Amplituden des ersten und zweiten Suchspulensignals sowie der momentanen Phase des zweiten Suchspulensignals umfasst.

7. Verfahren nach Anspruch 6, wobei das Ausgangssignal gemäß der folgenden Gleichung berechnet wird:

$$w[n] = (a_1[n] + j \cdot a_2[n])e^{j(\varphi[n])};$$

where $j = \sqrt{-1}$ und wobei $a_1$ und $a_2$ die momentanen Amplituden des ersten und des zweiten Suchspulensignals sind, und $\varphi[n]$ die momentane Phase des ersten Suchspulensignals ist.

8. Verfahren nach einem der oberen Ansprüche, wobei der Schritt der Überwachung die folgenden Schritte umfasst:

    - Darstellen einer Ansicht des aktuellen Zustands und einer entsprechenden Ansicht der Zustandsbasislinie in einem gemeinsamen Koordinatensystem, das zur visuellen Kontrolle angeordnet ist.

9. Verfahren nach Anspruch 8, wobei der Schritt des Darstellens ein Anzeigen der momentanen Amplitude als Funktion der momentanen Phase für den aktuellen Zustand und die entsprechende Zustandsbasislinie in einem gemeinsamen Augendiagramm umfasst.

10. Verfahren nach einem der Ansprüche 7 bis 9, wobei der Schritt des Überwachens ferner das Darstellen des komplexen Ausgangssignals w[n] als 2D-Plot umfasst.

11. Verfahren nach Anspruch 2, wobei der Schritt des Überwachens die folgenden Schritte umfasst:

    - Berechnen von Abweichungen zwischen dem aktuellen Zustand und der Zustandsbasislinie; und mindestens einen der folgenden Schritte:
    - i) Darstellen der Abweichungen, angeordnet zur manuellen Auswertung; und
    - ii) automatisches Auswerten der Abweichungen.

12. Verfahren nach Anspruch 11, wobei der Schritt des automatischen Auswertens der Abweichungen rechnergestützt erfolgt.

13. Zustandsüberwachungsvorrichtung für eine permanentmagnetische elektrische Maschine, wobei die elektrische Maschine einen Rotor mit einer Anzahl von Permanentmagneten und einen Stator mit Statorzähnen umfasst, und wobei mindestens eine erste Suchspule an einem ersten der Statorzähne angeordnet ist, wobei die Vorrichtung zur Durchführung des Verfahrens nach einem der vorherigen Ansprüche eingerichtet ist, und wobei die Vorrichtung umfasst:

    - die mindestens erste Suchspule;
    - Mittel zum Empfangen eines Suchspulensignals von der mindestens ersten Suchspule;
    - Mittel zum Umwandeln eines analogen Suchspulensignals von der Suchspule in ein digitales Suchspulensignal;
    - Mittel zum Filtern des digitalen Suchspulensignals durch einen analytischen Hilbert-Bandpassfilter in ein analytisches Signal;
    - Mittel zum Extrahieren von Amplitude, momentaner Frequenz und momentaner Phase des analytischen Signals; und
    - Mittel zur Überwachung des Zustands.

14. Zustandsüberwachungsvorrichtung nach Anspruch 13, wobei das Mittel einen Computer und einen Monitor umfasst.

15. Ein permanentmagnetisches elektrisches Maschinensystem, umfassend:

    - eine permanentmagnetische elektrische Maschine, umfassend einen Rotor mit einer Anzahl von Permanentmagneten, einen Stator mit Statorzähnen; und
    - eine Zustandsüberwachungsvorrichtung nach einem der Ansprüche 13 bis 14.

16. System nach Anspruch 15, wobei die Zustandsüberwachungsvorrichtung nur eine Suchspule umfasst und die Suchspule um einen der Statorzähne angeordnet ist.

17. System nach Anspruch 15, wobei die Zustandsüberwachungsvorrichtung zwei Suchspulen umfasst, die auf separaten Statorzähnen so angeordnet sind, dass die Mittelachsen der zwei Suchspulen orthogonal sind.

**Revendications**

1. Procédé de surveillance de santé pour une machine électrique à aimant permanent, où la machine électrique comprend un rotor ayant un certain nombre d'aimants permanents et un stator ayant des dents de stator, et où au moins une première bobine exploratrice est agencée sur une première dent parmi les dents de stator, où le procédé comprend les étapes suivantes :

I) Étapes initiales :

- l'établissement d'une ligne de base d'état sur la base de l'un parmi ce qui suit : i) une ligne de base d'état prédéfini, et ii) un état actuel pour la machine électrique à aimant permanent, PM, en fonctionnement sans défaut, où l'état actuel est établi par les étapes ci-dessous de prétraitement, de filtrage, d'extraction et d'établissement de l'état actuel ;

II) Étapes fonctionnelles :

- le prétraitement d'un signal de bobine exploratrice analogique provenant de chaque bobine exploratrice par l'application d'un filtre anti-repliement fournissant un signal de bobine exploratrice anti-replié, et la conversion du signal de bobine exploratrice anti-replié en un signal de bobine exploratrice numérique ;
- le filtrage du signal de bobine exploratrice numérique par un filtre de Hilbert analytique passe-bande, fournissant un signal de bobine exploratrice analytique ;
- l'extraction de caractéristiques à partir du signal de bobine exploratrice analytique ;
- l'établissement d'un état actuel sur la base des caractéristiques extraites ;
- la surveillance de la santé de la machine électrique à aimant permanent sur la base de l'état actuel et de la ligne de base d'état.

2. Procédé selon la revendication 1, où le signal de bobine exploratrice numérique s[n] est filtré par le filtre de Hilbert analytique passe-bande fournissant le signal analytique (complexe) *u[n] = H{s[n}}* où H possède une réponse en fréquence donnée par l'équation :

$$H(f) = \begin{cases} 2 & pour\ 0 \leq f \leq f_c \\ 0 & pour\ f < 0 \quad ; \quad f \in [-0,5\,;\,0,5) \\ 0 & pour\ f > f_c \end{cases}$$

où *f* est une fréquence normalisée donnée par l'équation ci-dessous

$$f = \frac{F}{F_s}; \qquad f \in [-0,5\,;\,0,5)$$

où *Fs* est une fréquence d'échantillonnage [$S_a$/s].

3. Procédé selon l'une des revendications ci-dessus, où l'étape d'extraction de caractéristiques pour la première bobine exploratrice comprend les étapes suivantes :

- le calcul de l'amplitude instantanée comme étant la valeur absolue du signal de bobine exploratrice analytique,
- l'estimation de la fréquence instantanée sur la base du signal de bobine exploratrice analytique ; et
- l'accumulation de la phase instantanée sur la base de la fréquence instantanée.

4. Procédé selon la revendication 3, où la fréquence instantanée est estimée sur la base d'un signal $u_1$ de bobine exploratrice analytique même si davantage de signaux de bobine exploratrice doivent être disponibles

$$f_{inst}[n] = \frac{Im\left(\ln\left(\frac{u_1[n]}{u_1[n-1]}\right)\right)}{2\pi n_m} \qquad ,$$

où Im désigne la partie imaginaire, ln désigne le logarithme naturel, et n est un temps discret [Sa], et $n_m$ désigne le nombre d'aimants dans le rotor, et où la phase instantanée est obtenue à partir de la fréquence instantanée de la manière suivante :

$$\varphi[n] = \begin{cases} 0 & pour\ n = -1 \\ 2\pi fr(f_{inst}[n] + \dfrac{\varphi[n-1]}{2\pi}) & pour\ n = 0, 1, \dots \end{cases}$$

où fr() désigne la fonction fraction.

5. Procédé pour l'évaluation de la santé d'une machine électrique à aimant permanent selon l'une des revendications ci-dessus, où la machine électrique comprend une seconde bobine exploratrice agencée sur une seconde dent parmi les dents de stator, et agencée à un angle de 90 degrés par rapport à la première bobine exploratrice, où l'étape d'extraction de caractéristiques pour la seconde bobine exploratrice comprend l'étape suivante :

   - le calcul de l'amplitude instantanée comme étant la valeur absolue du signal de bobine exploratrice analytique.

6. Procédé selon la revendication 5, où l'étape d'extraction de caractéristiques comprend en outre le calcul d'un signal de sortie complexe sur la base des amplitudes instantanées des signaux de première et seconde bobine exploratrice et de la phase instantanée du signal de seconde bobine exploratrice.

7. Procédé selon la revendication 6, où le signal de sortie est calculé selon l'équation suivante :

$$w[n] = (a_1[n] + j \cdot a_2[n])e^{j(\varphi[n])} \ ;$$

où $j = \sqrt{-1}$ et où $a_1$ et $a_2$ sont les amplitudes instantanées des signaux de première et seconde bobine exploratrice, et $\varphi[n]$ est la phase instantanée du signal première de bobine exploratrice.

8. Procédé selon l'une des revendications ci-dessus, où l'étape de surveillance comprend les étapes suivantes :

   - la présentation d'une vue de l'état actuel et d'une vue correspondante de la ligne de base d'état dans un système de coordonnées commun agencé pour une inspection visuelle.

9. Procédé selon la revendication 8, où l'étape de présentation comprend l'affichage de l'amplitude instantanée en fonction de la phase instantanée pour l'état actuel et la ligne de base d'état correspondante dans un diagramme de l'œil commun.

10. Procédé selon l'une des revendications 7 à 9, où l'étape de surveillance comprend en outre la présentation du signal de sortie complexe *w[n]* sous la forme d'un tracé bidimensionnel, 2D.

11. Procédé selon la revendication 2, où l'étape de surveillance comprend les étapes suivantes :

   - le calcul d'écarts entre l'état actuel et la ligne de base d'état ; et
   au moins l'une des étapes suivantes :
   - i) la présentation des écarts agencés pour une évaluation manuelle ; et
   - ii) l'évaluation automatique des écarts.

12. Procédé selon la revendication 11, où l'étape d'évaluation automatique des écarts est informatisée.

13. Dispositif de surveillance de santé pour une machine électrique à aimant permanent, où la machine électrique comprend un rotor ayant un certain nombre d'aimants permanents et un stator ayant des dents de stator, et où au moins une première bobine exploratrice est agencée sur une première dent parmi les dents de stator, où le dispositif est agencé pour réaliser le procédé selon l'une des revendications ci-dessus, et où le dispositif comprend :

- l'au moins première bobine exploratrice ;
- un moyen pour recevoir un signal de bobine exploratrice de l'au moins première bobine exploratrice ;
- un moyen pour convertir un signal de bobine exploratrice analogique provenant de la bobine exploratrice en un signal de bobine exploratrice numérique ;
- un moyen pour filtrer le signal de bobine exploratrice numérique par un filtre analytique passe-bande de Hilbert en un signal analytique ;
- un moyen pour extraire l'amplitude, la fréquence instantanée et la phase instantanée du signal analytique ; et
- un moyen pour surveiller la santé.

**14.** Dispositif de surveillance de santé selon la revendication 13, où le moyen comprend un ordinateur et un moniteur.

**15.** Système de machine électrique à aimant permanent, comprenant :

- une machine électrique comprenant un rotor ayant un certain nombre d'aimants permanents, un stator ayant des dents de stator ; et
- un dispositif de surveillance de santé selon l'une des revendications 13 à 14.

**16.** Système selon la revendication 15, où le dispositif de surveillance de santé comprend une seule bobine exploratrice, et la bobine exploratrice est agencée autour de l'une des dents de stator.

**17.** Système selon la revendication 15, où le dispositif de surveillance de santé comprend deux bobines exploratrices agencées sur des dents de stator séparées de sorte que les axes centraux des deux bobines exploratrices soient orthogonaux.

Fig. 1

Fig. 2

EP 3 657 188 B1

Fig. 3

Fig. 4

Fig. 5a

Fig. 5b

Fig. 5c

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20130033215 A1
- US 20130108488 A1
- US 20130325373 A1

**Non-patent literature cited in the description**

- Demagnetization Modeling and Fault Diagnosing Techniques in Permanent Magnet Machines Under Stationary and Nonstationary Conditions: An Overview. **FIAZ et al.** IEEE TRANSACTIONS ON INDUSTRY APPLICATIONS. IEEE SERVICE CENTER, 01 May 2017, vol. 53, 2772-2785
- Detection and analysis of winding and demagnetization faults in PMSM based marine propulsion motors. **AHSANULLAH et al.** IEEE INTERNATIONAL ELECTRIC MACHINES AND DRIVES CONFERENCE (IEMDC). IEEE, 21 May 2017, 1-7
- Torque-Ripple-Based Interior Permanent-Magnet Synchronous Machine Rotor Demagnetization Fault Detection and Current Regulation. **ZHU et al.** IEEE TRANSACTIONS ON INDUSTRY APPLICATIONS. IEEE SERVICE CENTER, 01 May 2017, vol. 53, 2795-2804
- SEIG-based wind turbine condition monitoring using stray flux instantaneous frequency estimation. **MOHAMED et al.** IEEE 24TH INTERNATIONAL SYMPOSIUM ON INDUSTRIAL ELECTRONICS (ISIE). IEEE, 03 June 2015, 861-866